(19) Europäisches Patentamt
European Patent Office
Office européen des brevets

(11) **EP 1 591 557 B1**

(12) **EUROPÄISCHE PATENTSCHRIFT**

(45) Veröffentlichungstag und Bekanntmachung des Hinweises auf die Patenterteilung:
**16.04.2008 Patentblatt 2008/16**

(51) Int Cl.:
*C23C 14/34* *(2006.01)*     *C23C 14/54* *(2006.01)*
*C23C 14/56* *(2006.01)*     *C23C 14/00* *(2006.01)*

(21) Anmeldenummer: **04023123.5**

(22) Anmeldetag: **29.09.2004**

(54) **Verfahren zum Beschichten von Substraten in Inline-Anlagen**

Coating method for In-line apparatus.

Procédé de revêtement pour appareil en ligne.

(84) Benannte Vertragsstaaten:
**AT BE BG CH CY CZ DE DK EE ES FI FR GB GR HU IE IT LI LU MC NL PL PT RO SE SI SK TR**

(30) Priorität: **26.04.2004 DE 102004020466**

(43) Veröffentlichungstag der Anmeldung:
**02.11.2005 Patentblatt 2005/44**

(73) Patentinhaber:
• **Applied Materials GmbH & Co. KG**
  **63755 Alzenau (DE)**
• **Fraunhofer-Gesellschaft zur Förderung der angewandten Forschung e.V.**
  **80686 München (DE)**

(72) Erfinder:
• **Pflug, Andreas, Dipl.-Phys.**
  **30175 Hannover (DE)**
• **Szyszka, Bernd. Dr.**
  **38108 Braunschweig (DE)**
• **Kastner, Albert, Dipl.-Phys.**
  **63457 Hanau (DE)**
• **Geisler, Michael, Dr.**
  **63607 Wächtersbach (DE)**
• **Leipnitz, Thomas, Dipl.-Ing.**
  **63755 Alzenau (DE)**
• **Bruch, Jürgen, Dipl.-Ing.**
  **61130 Nidderau (DE)**

(74) Vertreter: **Schickedanz, Willi**
  **Langener Strasse 68**
  **63073 Offenbach (DE)**

(56) Entgegenhaltungen:
**US-A- 5 057 185**     **US-A1- 2003 141 184**
**US-B1- 6 488 824**

• **PFLUG A ET AL: "Simulation of reactive sputtering kinetics in real in-line processing chambers" PREPARATION AND CHARACTERIZATION, ELSEVIER SEQUOIA, NL, Bd. 442, Nr. 1-2, 1. Oktober 2003 (2003-10-01), Seiten 21-26, XP004458291 ISSN: 0040-6090**

**Beschreibung**

Die Erfindung betrifft ein Verfahren zum Beschichten von Substraten in Inline-Anlagen, bei denen ein Substrat durch wenigstens eine Beschichtungskammer bewegt und während der Bewegung beschichtet wird.

Derartige Inline-Anlagen bestehen aus mehreren Beschichtungskammern, die hintereinander angeordnet sind und in denen Substrate vorzugsweise mittels eines Sputterprozesses beschichtet werden.

Die Substrate werden dabei an Sputtervorrichtungen vorbeibewegt, wobei sie kontinuierlich beschichtet werden, sodass eine Schicht von bestimmter Dicke entsteht.

Die Sputtervorrichtungen befinden sich jeweils in Beschichtungskammern, die über Verbindungs- bzw. Transportkanäle mit benachbarten Kammern verbunden sind. Die Vakuum-Leitfähigkeit der Transportkanäle ist in der Regel klein verglichen mit der Vakuumleitfähigkeit einer Beschichtungskammer in Querrichtung. Bei den benachbarten Kammern kann es sich um weitere Beschichtungskammern oder um Pumpkompartments handeln.

Die Pumpkompartments stellen differentielle Pumpstufen zwischen den Beschichtungskammern her, so dass zwischen den Beschichtungskammern eine gewisse Gastrennung gewährleistet ist, die aber nicht vollständig ist. Dieses Vorgehen ist für eine wirtschaftliche Arbeitsweise wichtig.

Während des Transports der Substrate durch die Beschichtungskammer werden bestimmte Kammerparameter, insbesondere die Vakuumleitwerte der Verbindungskanäle und effektive Saugvermögen von Pumpkompartments in charakteristischer Weise verändert. Anhand der Maschinenparameter der Anlage wird dies durch charakteristische Schwankungen der Gaspartialdrücke sowie der Katodenspannung sichtbar; letzteres bewirkt eine zeitlich schwankende Beschichtungsrate. Hierdurch wird die Beschichtung des Substrats in Bewegungsrichtung nicht gleichmäßig. Dies ist insbesondere bei Beschichtungen von großflächigem Architekturglas nachteilig, weil die optischen Eigenschaften dieser Beschichtungen stark von der Dicke der Schicht abhängen.

Um die Veränderungen der Vakuum-Leitwerte und des effektiven Saugvermögens vorherzusagen, kann die Monte-Carlo-Methode herangezogen werden. Hierbei handelt es sich um ein stochastisches Rechenverfahren zur numerischen Bestimmung von Nährungslösungen verschiedener mathematischer, insbesondere wahrscheinlichkeitstheoretischer Probleme. Die für die Gasflusssimulation zu berechnenden makroskopischen Größen wie z. B. Druck und Temperatur ergeben sich hierbei als Mittelwerte aus mikroskopischen Größen wie z. B. Teilchengeschwindigkeiten, die aus einer Vielzahl von repräsentativen Gasteilchen im Rahmen eines stochastischen Bewegungs- und Kollisionsmodells gewonnen werden. Die effektive Anwendung der Monte-Carlo-Methode wurde in diesem Rahmen erst durch schnell arbeitende Computer ermöglicht.

Die Monte-Carlo-Simulation von Gasflüssen mittels stochastischer Bewegungs- und Kollisionsmodelle für Modell-Moleküle ist bereits bekannt (G. A. Bird: Recent Advances and Current Challenges for DSMC, Computers Math. Applic. Vol. 35, No. 1/2, 1998, S. 1 - 14).

Weiterhin ist es bekannt, ein makroskopisches, idealisiertes Modell für das reaktive Sputtern zu schaffen, beispielsweise für das reaktive Sputtern von Ti in einer Gasmischung von Argon und Stickstoff (S. Berg, H.-O. Blom, T. Larsson, and C. Nender: Modeling of reactive sputtering of compound materials, J. Vac. Sci. Technol. A5 (2), Mar/Apr. 1987, S. 202 - 207).

Dieses Modell beschreibt das reaktive Sputtern mittels des reaktiven Gasflusses zum Target und zum Substrat, mittels Sputterausbeuten bei reinem und oxidiertem Target, mittels Haftkoeffizient der reaktiven Moleküle bezüglich der Substrate und dem Target und mittels des Ionenstroms zur Targetoberfläche. Die Hauptfaktoren des reaktiven Sputtern wie Hysterese, Effekte der Pumpgeschwindigkeit etc. werden dabei berücksichtigt, nicht jedoch die Plasmaphysik und -chemie der Glimmentladung.

Die Plasmachemie wurde indessen durch Ershov und Pekker berücksichtigt (Model of d. c. magnetron reactive sputtering in Ar-$O_2$, gas mixtures (Thin Solid Films 289, 1996, S. 140 - 146).

Es ist auch bekannt, mit Hilfe von Monte-Carlo-Simulationsverfahren Informationen über die räumliche Verteilung von Flüssen von gesputterten Teilchen in einer Sputterkammer sowie über deren Verteilung der kinetischen Energie beim Auftreffen auf das Substrat zu erhalten (Karol Macäk, Peter Macäk, Ulf Helmersson: Monte Carlo simulations of the transport of sputtered particles, Computer Physics Communications 120, 1999, S. 238 - 254).

Die Simulation der Kinetik vom reaktiven Sputtern bei In-Line-Kammern ist ebenfalls bekannt (A. Pflug, N. Malkomes, V. Sittinger, and B. Szyszka: Simulation of Reactive Magnetron Sputtering Kinetics in Real In-Line Processing Chambers, Thin Solid Films 442, 2003, S. 21 - 26). Hierbei wird das komplexe Volumen einer Prozesskammer in einfache Volumenzellen unterteilt, beispielsweise in Parallelepipede. In jeder Zelle werden homogene Partialdrücke für Inert- und Reaktivgas sowie homogene Oxidationsgrade pro Fläche angenommen und die Prozesse des Sputterns und der Abscheidung anhand einfacher Ratengleichungen entsprechend des Modells von Berg et al. beschrieben. Durch dreidimensionale Vernetzung der Volumenelemente lässt sich die Prozessdynamik auch in komplexen Geometrien mit Hilfe gekoppelter Differentialgleichungen beschreiben und mittels adaptiver Runge-Kutta-Zeitschrittverfahren berechnen.

Gas- und Sputterpartikeltransport zwischen den Volumenelementen werden zunächst mit Hilfe von parallelen Monte-Carlo-Verfahren detailliert berechnet. Die sich hieraus ergebenden Vakuum-Leitwerte und Partikelverteilungs-Matrizen werden später in das kinetische, makroskopische Modell eingesetzt. Hierdurch erreicht man eine hohe Detailtreue in dreidimensionalen Anlagen, verbunden mit einer Recheneffizienz, die das System für Echtzeitanwendungen nutzbar macht.

Mit Hilfe eines erweiterten Berg'schen Modells, einer heuristischen Beziehung zwischen Sputterleistung, Targetspannung und Ionenstrom wurde auch bereits ein realistisches Modell zum Verhältnis von Niederschlagsparametern im metallischen Mode geschaffen (A. Pflug, B. Szyszka, V. Sittinger, and J. Niemann: Process Simulation for Advanced Large Area Optical Coatings, 2003, Society of Vacuum Coaters, 46th Annual Technical Conference Proceedings, 2003, S. 241 - 247). Dieses Modell gestattet die Anbindung der Simulation an Maschinenparameter wie Targetspannung und Sputterleistung sowie ferner die Simulation inhomogener Sputterbedingungen mittels Segmentierung langer Targets.

Mehrere der vorstehend erwähnten Simulationsverfahren wurden auch in einer Simulationssoftware zusammengefasst (A. Pflug, B. Szyszka, J. Niemann: Simulation des reaktiven Magnetron-Sputterprozesses in Inline-Anlagen, JOT 1, 2003, S. X - XIII). Hierbei wurden mit Hilfe von Monte-Carlo-Verfahren auf einem Linux-Cluster Gasfluss-Kinetik sowie Verteilung der gesputterten Partikel auf Kammerinnenflächen dreidimensional berechnet. Das vorstehend erwähnte Bird'sche Verfahren zur GasflussSimulation sowie das ebenfalls vorstehend erwähnte Verfahren von Macák et al. zur Simulation von Partikel-Trajektorien wurden dabei als Parallelalgorithmen in C++ unter der Parallelumgebung "Parallel Virtual Machine" implementiert.

Bei dem Linux-Cluster handelt es sich um mehrere zusammengeschaltete PCs, die unter dem Betriebssystem Linux operieren. "Cluster" bedeutet zunächst, dass mehrere Prozessoren parallel an einem Problem rechnen. In der Praxis wird ein Cluster aus Kostengründen oft aus handelsüblichen PCs aufgebaut, wobei man das beste Preis-/Leistungsverhältnis oft mit Dual Baord PCs erhält. Die PCs sind miteinander über ein separates Netzwerk vernetzt, um darüber während der Berechnung die notwendige Kommunikation zwischen den Teilprozessen abwickeln zu können.

Das vorstehend erwähnte makroskopische dynamische Modell zur Berechnung der zeitaufgelösten Prozessdynamik in dreidimensonalen In-Line-Anlagen wurde ebenfalls im Rahmen dieses Softwaresystems implementiert. Dieses Modell ist für Echtzeitanwendungen geeignet und importiert die aus den Monte-Carlo-Rechnungen erhaltenen Informationen in Form von Strömungsleitwerten für die Gasfluss-Kinetik sowie Verteilungs-Matrizen für die gesputterten Partikel.

Weitere Simulationsverfahren für den Sputtervorgang sind ebenfalls bekannt (US 5 751 607, US 6 070 735, US 6 512 998, KR 2000023859, JP 10294293 A, JP 2003282381 A, US 6 512 998 B1). Diese beziehen sich jedoch allesamt auf Verfahren zur Simulation gesputterter Neutralpartikel. Der Einfluss der Neutralpartikelverteilung auf die makroskopische Sputterprozess-Kinetik ist indessen verschwindend gering und damit für die vorliegende Erfindung von untergeordneter Bedeutung. Schichtdickenregelungen sind aus den US-Patentschriften 2003/0 141 184, 6 425 988, 6 524 449 und 6 668 207 bekannt.

Der Erfindung liegt die Aufgabe zugrunde, ein Verfahren zu schaffen, bei dessen Anwendung die Beschichtung eines Substrats in Richtung der Bewegung des Substrats durch die Beschichtungskammer eine gleichmäßige Dicke aufweist.

Diese Aufgabe wird durch die Merkmale des Patentanspruchs 1 gelöst.

Bei der Erfindung wird also ein Modell der Beschichtungsanlage verwendet, das exakt den Rezipienten beschreibt, einschließlich der Volumenform und der Oberflächenform sowie aller dreidimensional aufgelösten Partialdrücke und Partialflüsse, wie sie sich räumlich und zeitlich entsprechend den Quellen und Senken aller chemischen Produkte, einschließlich der Elektronen und Ionen, herausbilden. Außerdem wird ein Modell des Sputter- und Niederschlagsprozesses gebildet.

Der mit der Erfindung erzielte Vorteil besteht insbesondere darin, dass während des Beschichtungsprozesses auch Parameter berücksichtigt werden können, die einer direkten Messung während des Beschichtungsprozesses nicht zugänglich sind, beispielsweise die Sputterraten an den Beschichtungstargets oder die mittlere Depositionsrate auf dem Substrat. Zwar ist die Schichtdicke mit Hilfe einer In-Situ-Spektroskopie messbar, doch müssten für die Bestimmung der Beschichtungsrate mindestens zwei Schichtdicken zu zwei Zeitpunkten bestimmt werden. Dies ist aufgrund der Substratbewegung nahezu unmöglich, sofern die Optik nicht in Bewegungsrichtung mitgeführt wird. Durch simulierte virtuelle Regelkreise können somit entweder die Sputterraten oder die mittlere Beschichtungsrate auf dem Substrat konstant gehalten werden. Gelingt es mit einer Korrekturvorschrift, die Sputterraten von z. B. zwei Targets konstant zu halten, würde daraus auch eine konstante Beschichtungsrate resultieren.

Bei der Anwendung der sich aus dem virtuellen Regelkreis ergebenden Regel- oder Korrekturvorschrift auf den realen Sputterprozess resultiert eine verbesserte Gleichmäßigkeit der Beschichtungsdicke in Richtung der Bewegung des Substrats. In der Simulation wird die Beschichtungsrate auf dem Substrat mittels eines Regelkreises konstant gehalten. Hieraus ergibt sich eine Korrekturvorschrift, z. B. für den Gasfluss.

Für eine gleichmäßige Schichtdicke auf dem Substrat ist es hinreichend, alle relevanten Betriebsbedingungen eines Beschichtungstargets und -Rezipienten zeitlich konstant zu halten. Unter "Betriebsbedingungen" werden hierbei die Gasdrücke zwischen Target und Substrat sowie die Sputterraten der Targets verstanden, die von außen nicht direkt zugänglich sind. So wird beispielsweise der Druck nicht direkt zwischen Target und Substrat, sondern irgendwo an einer Rezipientenwand gemessen. Bei Beschichtungssystemen, die aus mehreren Targets bestehen, beispielsweise einer Doppelkathode, haben Untersuchungen gezeigt, dass die zeitliche Konstanz der Betriebsbedingungen aller Targets mit einer einfachen Regelvorschrift in der Regel nicht erzielt werden kann. Die Sputterraten der einzelnen Targets zeigen charakteristische zeitliche Verläufe, die sich bei Anwendung der Regelvorschrift auf dem Substrat jedoch im Mittel zu einer gleichmäßigen Beschichtungsrate kompensieren. Mit komplizierteren Korrekturvorschriften, z. B. zwei unabhängigen Korrekturkurven für einen rechten und einen linken Gaseinlass, wäre es ebenfalls möglich, die Sputterbedingungen an zwei Targets konstant zu halten.

Eine detaillierte Kompensation aller durch die Substratbewegung veränderten Saugleistungen und Vakuum-Leitwerte wäre unabhängig vom Sputterprozess und könnte, sobald die entsprechende Regel- oder Korrekturvorschrift einmal für eine bestimmte Anlagengeometrie berechnet wurde, unabhängig vom Targetmaterial und Arbeitspunkt des Sputterprozesses angewendet werden.

Bei komplex aufgebauten Beschichtungsquellen, beispielsweise den vorstehend erwähnten Doppelkathoden, bewirkt eine einfache Regelvorschrift jedoch vielmehr eine weitere zusätzliche Schwankung in bestimmten Prozessparametern, mit deren Hilfe eine anfänglich vorhandene Schichtdicken-Inhomogenität auf dem Substrat in Bewegungsrichtung im Mittel aller Teilchenflüsse kompensiert wird. In diesen Fällen ist die Regelvorschrift auch vom Material und Arbeitspunkt des Sputterprozesses abhängig. Das Sputtermodell kann in diesen Fällen für ein Targetmaterial auf einen bestimmten Parameterbereich des Sputterprozesses geeicht werden und innerhalb dieses Bereichs die entsprechend erforderlichen Regelvorschriften in kurzer Zeit ausgeben.

In der vorliegenden Erfindung sind sowohl die detaillierte Kompensation aller Betriebszustände innerhalb der Beschichtungskammer als auch die indirekte Kompensation der Schichtdicken-Inhomogenität mittels einer weiteren, zeitabhängigen Schwankung in bestimmten Prozessparametern enthalten.

Ein Ausführungsbeispiel der Erfindung ist in den Zeichnungen dargestellt und wird im Folgenden näher beschrieben. Es zeigen:

Fig. 1 einen Querschnitt durch eine Sputterkammer;

Fig. 2 eine schematische Darstellung eines verwendeten Modells einer Sputterkammer;

Fig. 3 eine nähere Darstellung einer simulierten, virtuellen Steuerung, ohne In-situ-Prozessregelung;

Fig. 4 eine nähere Darstellung einer simulierten, virtuellen Steuerung, mit In-situ-Prozessregelung.

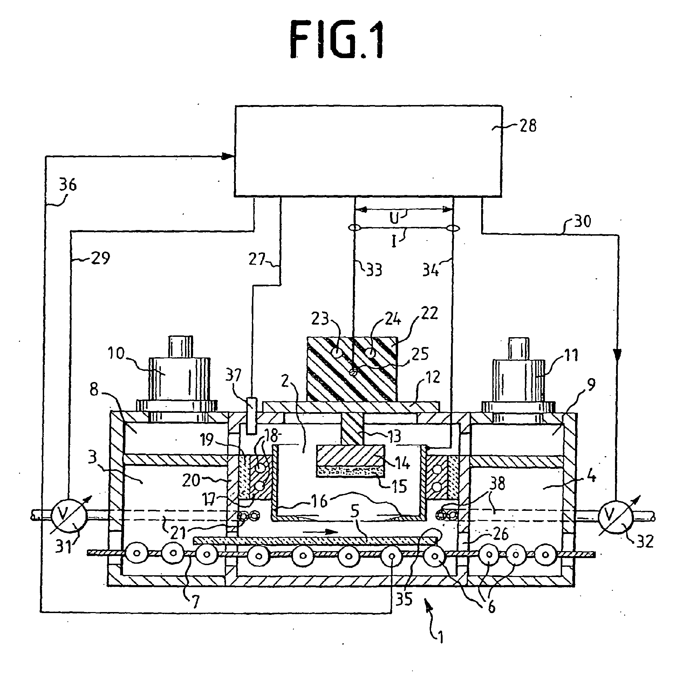

In der Fig. 1 ist eine Sputterkammer 1 dargestellt, welche die eigentliche Beschichtungskammer 2 und zwei Pufferkammern 3, 4 aufweist. An diese Sputterkammer 1 können sich rechts und/oder links weitere Sputterkammern anschließen, die nicht dargestellt sind. Ein Substrat 5 wird über Transportrollen 6, die in einem Träger 7 gelagert sind, von links nach rechts transportiert. Über der Pufferkammer 3, 4 befindet sich jeweils eine Pumpkammer 8, 9, wobei über jeder Pumpkammer 8, 9 eine Pumpe 10, 11 angeordnet ist. Bei den Pumpen 10, 11 handelt es sich um Turbopumpen, die eine fest vorgegebene Nenndrehzahl und bei dieser ein festes Saugvermögen haben. Bei dem hier gewählten Modell geht das feste Saugvermögen der Pumpen 10, 11 als fixe Größe ein. Zwischen den Pumpen 10, 11 befindet sich ein Anlagendeckel 12, auf dessen Unterseite eine Ihathodenhalterung 13 befestigt ist, die eine Kathode 14 mit einem Target 15 trägt. Eine Anode 16, die sich unterhalb des Targets 15 befindet, ist an einer Halterung 17 befestigt, die ein Kühlsystem 18 enthält und über eine Isolierung 19 mit einer Wand 20 der Beschichtungskammer 2 verbunden ist. Neben der Anode 16 sind Zuleitungen 21 für Sputtergase vorgesehen. In einer Kathodenabdeckhaube 22 sind Kathodenkühlwasserrohre 23. 24 vorgesehen, die für den Vor- und Rücklauf von Kühlwasser dienen. Mit 25 ist der Kathodenanschluss bezeichnet. Eine Spaltschleuse 26 verbindet die Beschichtungskammer 2 mit der Pufferkammer 4.

Obgleich die Fig. 1 nur eine Kathode 14 bzw. ein Target 15 zeigt, ist die Erfindung auch auf Anlagen mit zwei oder mehreren Targets anwendbar.

Mit 37 ist ein Drucksensor bezeichnet, der über eine Leitung 27 mit einer Steuerung 28 verbunden ist, welche ein Modell der Sputterkammer 1 beinhaltet. Entsprechend wird der Gasdruck in der Beschichtungskammer 2 über Steuerleitungen 29, 30 und Ventile 31, 32 sowie die Kathoden-Anodenspannung über die Leitungen 33, 34 gesteuert. Der mittlere Druck P in der Beschichtungskammer 2 berechnet sich aus dem Verhältnis von Gaszufluss F zum effektiven Saugvermögen $S_{eff}$ aller angeschlossenen Pumpen:

$$P \: [\text{mbar}] = 0.01812 * F \: [\text{sccm}] / S_{eff} \: [\text{l/s}]$$

wobei sccm = Standard-Kubikzentimeter pro Minute und 1 sccm = 0.01812 mbar 1/s.

Die Position der Vorderkante 35 des Substrats 5 wird entweder fortlaufend gemessen oder errechnet. Wird sie errechnet, ist es erforderlich, den Zeitpunkt der Einführung des Substrats in die Sputterkammer 1 oder Beschichtungskammer 2 festzuhalten. Der Positionswert des Substrats 5 wird über eine Steuerleitung 36 an die Steuerung 28 gemeldet.

Die Steuerung 28 kann nun anhand der jeweils eingegebenen Position des Substrats 5 und mithilfe der aus dem Modell der Sputterkammer 1 in Verbindung mit einem Software-Regelkreis ermittelten Korrekturfunktion so eingestellt werden, dass eine gleichmäßige Beschichtung in Bewegungsrichtung des Substrats 5 erfolgt.

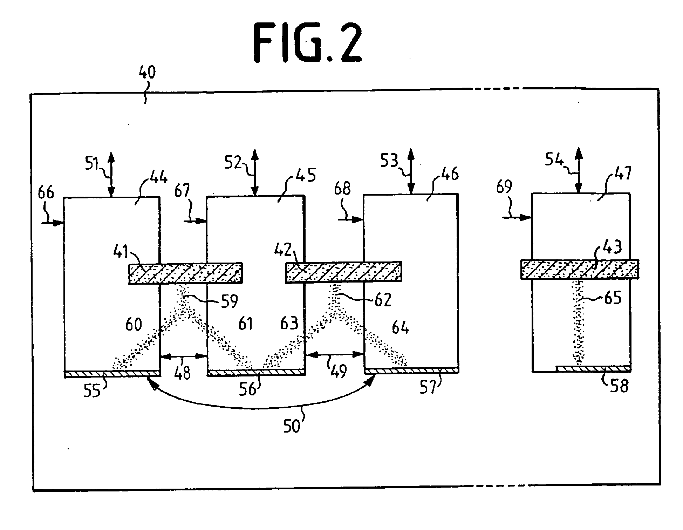

Die Fig. 2 zeigt eine schematische Darstellung eines verwendeten Modells einer Sputterkammer. Dieses Modell bezieht sich nicht auf die Fig. 1, sondern auf eine Kammer mit mehreren Targets.

Das der Erfindung zugrunde liegende, dynamische, makroskopische Modell 40 des reaktiven Sputterns berechnet die Wechselwirkung zwischen dem Sputterprozess und der Gasflusskinetik des Rezipienten in einer virtuellen Sputteranlage, die einen Teilbereich der realen Sputterkammer 1 gemäß Fig. 1 abbildet. Dieser Teilbereich umfasst eine Anzahl von M virtuellen Sputtertargets 41 bis 43 sowie einen Teil des Rezipientenvolumens im Sputterbereich, welcher in Form von Zellen 44, 45, 46, 47 in der Simulation abgebildet wird. In der Darstellung einer realen Sputteranlage gemäß Fig. 1 ist der Spezialfall von nur einem Sputtertarget 15 gezeigt. Das Modell 40 erlaubt jedoch eine beliebige Anzahl von virtuellen Sputtertargets 41 bis 43, um damit z. B. auch das Verhalten von Doppelkathoden usw. simulieren zu können.

Mit 55 bis 58 sind Flächen bezeichnet, die besputtert werden. Hierbei kann es sich um Substrate oder um Kammerwände handeln. Die Bezugszahlen 59, 62, 65 deuten die abgesputterten Partikel an, die sich dann über Zweige 60, 61 bzw. 63, 64 verteilen.

Der Gastransport zwischen den Zellen 44 bis 47 innerhalb dieses Teilbereichs wird durch Strömungsleitwerte 48 bis 50 gekennzeichnet, dagegen sind Gasein- und -ausströmungen an den Grenzen dieses Teilbereichs durch effektive Saugvermögen 51 bis 54 gekennzeichnet. Im Gegensatz zum effektiven Saugvermögen bezeichnet ein Strömungsleitwert $S_{44/45}$ das Verhältnis zwischen einer Netto-Gasströmung $F_{44/45}$ zwischen zwei Zellen 44, 45 und deren Druckdifferenz $p_{44} - p_{45}$:

$$S_{44/45} \, [l/s] = 0.01812 * F_{44/45} \, [sccm] \; / \; (p_{44} - p_{45}) \, [mbar]$$

Die Koeffizienten 48, 49, 50 der Strömungsleitwerte und 51, 52, 53, 54 der effektiven Saugvermögen werden mit Hilfe des so genannten "Direct Simulation Monte Carlo" (DSMC)-Verfahrens bestimmt.

Die Gesamtheit aller Koeffizienten 48, 49, 50 bildet im Falle von N Zellen 44 bis 47 eine symmetrische N * N-Matrix. Im vorliegenden Beispiel liegt für das DSMC-Verfahren eine separate Software vor, die als Parallelalgorithmus ausgeführt ist und auf einem Linux-Cluster ein echt-dreidimensionales Druck- und Strömungsprofil von gasdurchströmten Rezipienten berechnen kann. Dieses Verfahren muss für unterschiedliche Positionen des Substrats 5 wiederholt werden, so dass die Koeffizienten 48 bis 50 und 51 bis 54 in Form von Funktionen der Substratposition an das dynamische Modell 40 übergeben werden.

Den virtuellen Sputtertargets 41 bis 43 sind Koeffizienten zugeordnet, die z. B. den getternden Flächenanteilen der Targetfläche des Targets 41 in Zelle 44 entsprechen. Die Gesamtheit aller Koeffizienten bildet eine M * N-Matrix. Ferner ist jeder Zelle 44 bis 47 eine Substratfläche 55 bis 58 zugeordnet. Der Anteil des gesputterten Materials von Target 41 bis 43 auf Substratfläche 55 bis 58 wird durch die Koeffizienten 60, 61, 63, 64, 65 bestimmt, die in ihrer Gesamtheit ebenfalls als M * N-Matrix dargestellt werden können. Zur Bestimmung der Koeffizienten 60 bis 65 kommt ein weiteres Monte-Carlo Verfahren zur Simulation von Trajektorien gesputterter Neutralpartikel zum Einsatz (Karol Macák, Peter Macák, Ulf Helmersson: Monte Carlo simulations of the transport of sputtered particles, Computer Physics Communications 120, 1999, S. 238-254). Dieses Modell liegt ebenfalls als externes Softwaremodul vor, das in Fig. 2 nicht dargestellt ist.

Innerhalb jeder Zelle 44 bis 47 des dynamischen Modells 40 kommt nun jeweils ein Sputtermodell analog zu Berg et al. (S. Berg, H.-O. Blohm, T. Larsson, and C. Nender: Modeling of reactive sputtering of compound materials, J. Vac. Sci. Technol. A5(2), Mar/Apr. 1987, S. 202-207) zum Einsatz. Die Kopplung der Zellen 44 bis 47 untereinander ist demnach durch die Strömungsleitwerte 48 bis 50 und Targets 41 bis 43 mit deren Flächenanteilen und Sputteranteilen gegeben. Jede Zelle 44 bis 47 kann mit einem Gaseinlass 66 bis 69 verbunden werden. Mittels der Koeffizienten 51 bis 54 werden entweder direkt angeschlossene Pumpen oder Verbindungen zu benachbarten Sputterkammern, die nicht direkt im dynamischen Modell 40 gerechnet werden, repräsentiert. Das gesamte Modell 40 lässt sich letztlich als ein System gekoppelter, nichtlinearer, zeitabhängiger Differentialgleichungen auffassen, zu dessen Lösung es standardisierte, numerische Verfahren gibt (z. B. J. R. Cash, A. H. Carp, ACM Transactions on Mathematical Software 16 (1990), S. 201 ff).

Das originale Berg-Modell enthält keinen Mechanismus zur Berechnung der Targetspannung. Diese wird bei konstanter Leistung als konstant angesehen. Bei der vorliegenden Erfindung wurde die Sekundärelektronenausbeute des Targetmaterials in Abhängigkeit vom Oxidationszustand eingeführt, wodurch sich die Targetspannung in Abhängigkeit von der Leistung und anderen Prozessparametern berechnen lässt.

Um die Totaldruckabhängigkeit von Prozesskennlinien korrekt modellieren zu können, wurde außerdem ein Verlustmechanismus von Argon-Ionen an taraetnahe Flächen - z. B. Kammerwand, Blenden etc. - eingeführt. Insbesondere bei niedrigem Totaldruck trägt somit ein Teil der erzeugten Argon-Ionen nicht zum Sputterprozess bei, sondern wird von anderen targetnahen Flächen absorbiert.

Eine genauere Analyse der Prozesskennlinien zeigte ferner, dass es für eine korrekte Modellierung unumgänglich ist, die Spannungs- bzw. Energieabhängigkeit der Sputterausbeute in das Modell einzubeziehen. Dies wurde im Stand der Technik bisher unberücksichtigt gelassen.

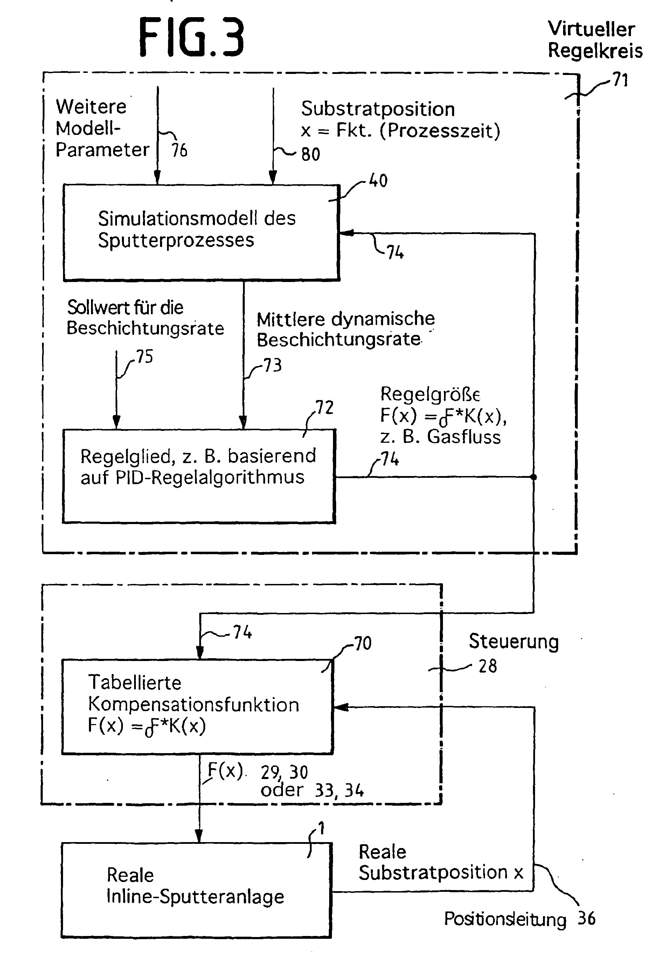

In der Fig. 3 ist eine nähere Darstellung des virtuellen Regelkreises zur Stabilisierung der Beschichtungsrate sowie der angeschlossenen Steuerung für den Fall ohne In-situ-Prozessregelung gezeigt.

Für die Korrektur von Schichtdickenschwankungen wird also zunächst der Fall betrachtet, in dem der gewählte Arbeitspunkt des Sputterprozesses keine weitere In-situ-Prozessstabilisierung erfordert. In diesem Fall ist in die Steuerung 28 einer Sputteranlage eine tabellierte oder parametrisierte Kompensationsfunktion 70 integriert, die von der Position des Glassubstrats 5 abhängt, wobei die Glasposition über die Steuerleitung 36 ausgelesen wird. Mit Hilfe der Korrekturfunktion 70 wird der Sputterprozess in der Sputteranlage 1 in Abhängigkeit der Substratposition moduliert. Im Ausführungsbeispiel geschieht dies entweder durch einen veränderlichen Gasfluss, der über die Steuerleitungen 29, 30 übermittelt wird oder über eine veränderliche Entladungscharakteristik, die als Gesamtleistung, Strom oder Spannung über Leitungen 33, 34 übermittelt wird.

Um eine zur Minimierung von Schichtdickenschwankungen geeignete Korrektur- oder Kompensationsfunktion 70 zu erhalten, wird im Vorfeld das dynamische Modell 40 des Sputterprozesses der Sputteranlage 1 erstellt und dieses Modell innerhalb eines virtuellen Regelkreises 71 an ein virtuelles Regelglied 72 angeschlossen. Das Regelglied 72 erhält die modellierte, mittlere dynamische Beschichtungsrate 73 auf dem Substrat als Regelgröße sowie einen Anlagenparameter 74 wie z. B. Gasfluss oder Entladungsleistung als Stellgröße. Das virtuelle Regelglied 72 bewirkt zunächst eine zeitlich gleichmäßige, mittlere Beschichtungsrate 73 in der Simulation.

Bei hinreichend guter Übereinstimmung zwischen Modell 40 und realer Anlage 1 kann der zeitliche Verlauf der Stellgröße 74 als Korrekturfunktion 70 für das reale Modell verwendet werden, so dass auch die reale Beschichtung auf dem Substrat 5 ein gleichmäßiges Schichtdickenprofil erhält.

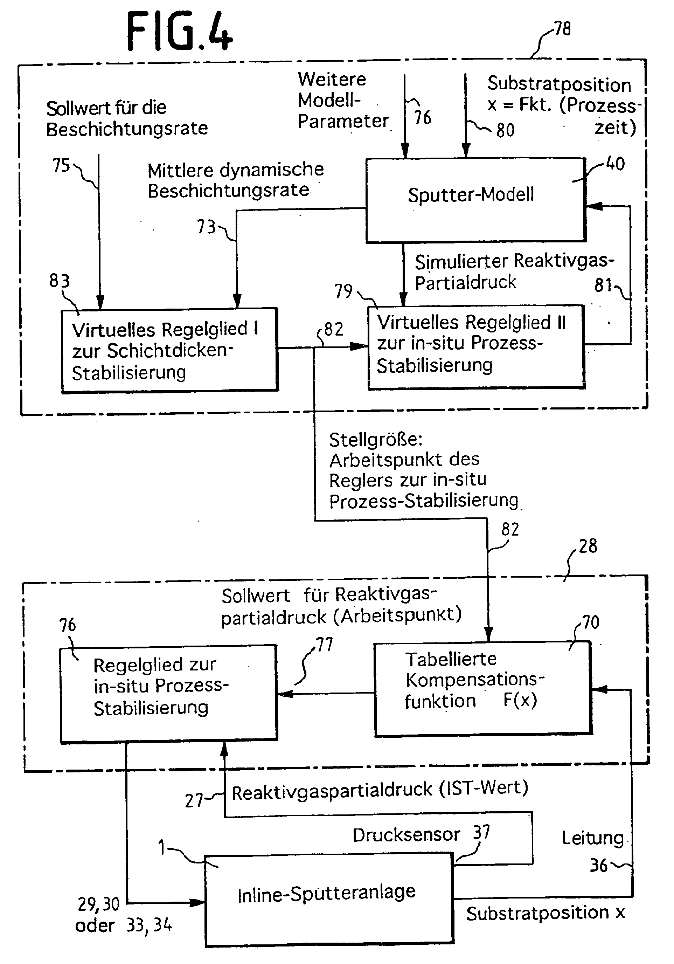

Die Fig. 4 zeigt eine nähere Darstellung eines virtuellen Regelkreises zur Stabilisierung der Beschichtungsrate sowie der angeschlossenen Steuerung für den Fall einer In-situ-Prozessregelung.

In einigen Fällen ist es erforderlich, auch die reale Sputteranlage 1 mit einem Regler 76 auszustatten, mit dem der mittels des Drucksensors 37 gemessene und über die Steuerleitung 27 übermittelte Reaktivgas-Partialdruck konstant gehalten wird. Als Stellgröße dient hier entweder die Entladungsleistung, übermittelt über die Leitungen 33, 34 oder der Inert oder Reaktivgasfluss, übermittelt über die Leitungen 29, 30. Derartige so genannte Stabilisierungen des Arbeitspunktes sind immer dann erforderlich, wenn der Arbeitspunkt im so genannten instabilen Übergangsbereich einer Sputterprozess-Kennlinie liegt.

In diesem Fall wird eine Korrekturfunktion 70 zur Minimierung von Schichtdickenschwankungen anstelle auf Anlagenparameter auf den Arbeitspunkt 77 des Reglers 76 angewendet. Die Substratposition x wird hierbei wiederum aus der Steuerung über die Leitung 36 eingelesen. Um hierfür die Korrekturfunktion zu erhalten, wird auf Simulationsebene ein doppelter, virtueller Regelkreis 78 aufgebaut: An das Simulationsmodell 40 der Sputteranlage ist ein virtuelles Regelglied 79 zu in-situ Prozess-Stabilisierung angeschlossen. Das virtuelle Regelglied 79 enthält idealerweise den gleichen Regelalgorithmus wie das reale Regelglied 76. Hiermit wird der simulierte Reaktivgaspartialdruck 81 aus einem virtuellen Drucksensor durch Variation eines Prozessparameters 64, z. B. Entladungsleistung oder Gasfluss, auf den Sollwert 82 geregelt.

Der Sollwert 82 wird nun mittels eines weiteren Regelglieds 83 derart geregelt, dass die mittlere, dynamische Beschichtungsrate 73 auf dem Substrat auf einen Sollwert 75 stabilisiert wird. Die Stellgröße des Reglers 83 entspricht dem Sollwert 82 des Reglers 79. Der zeitliche Verlauf der Stellgröße wird nach der Simulation wiederum als tabellierte Korrekturfunktion 70 in die Steuerung 28 der realen Anlage übertragen.

## Patentansprüche

1. Verfahren zum Beschichten von Substraten in Inline-Anlagen, bei denen ein Substrat durch wenigstens eine Beschichtungskammer bewegt und während dieser Bewegung beschichtet wird, **gekennzeichnet durch** folgende Schritte:

   a) es wird ein Modell (40) der Beschichtungskammer (2) gebildet, das die Änderungen von Kammerparametern berücksichtigt, die **durch** die Bewegung des Substrats (5) **durch** die Beschichtungskammer (2) verursacht werden;

b) es wird die Position des Substrats (5) innerhalb der Beschichtungskammer (2) erfasst;

c) die Kammerparameter werden aufgrund der Position des Substrats (5) nach Maßgabe des Modells (40) eingestellt.

2. Verfahren nach Anspruch 1, **dadurch gekennzeichnet, dass** das Modell (40) eine Korrekturfunktion (70) für einen oder mehrere Kammerparameter in Abhängigkeit von der Position des Substrats (5) bestimmt.

3. Verfahren nach Anspruch 1, **dadurch gekennzeichnet, dass** die Korrekturfunktion (70) in eine Steuerung (28) der Beschichtungsanlage (1) übertragen wird.

4. Verfahren nach Anspruch 1, **dadurch gekennzeichnet, dass** die Abmessungen des Substrats (5) in das Modell (40) eingegeben werden.

5. Verfahren nach Anspruch 1, **dadurch gekennzeichnet, dass** eine mittlere dynamische Beschichtungsrate (73) aufgrund des Modells (40) ermittelt wird und die ermittelte Beschichtungsrate (73) als Regelgröße in einen virtuellen Regler (72) gegeben wird, der durch Variation von Gasfluss oder Entladungsleistung (74) die mittlere dynamische Beschichtungsrate (73) konstant hält.

6. Verfahren nach Anspruch 5, **dadurch gekennzeichnet, dass** die Variation des Gasflusses oder der Entladungsleistung (74) als Korrekturfunktion (70) in die Steuerung (28) übertragen wird.

7. Verfahren nach Anspruch 1, **dadurch gekennzeichnet, dass** eine mittlere dynamische Beschichtungsrate (73) aufgrund des Modells (40) ermittelt wird und die ermittelte Beschichtungsrate (73) als Regelgröße in einen virtuellen Regler (83) gegeben wird, der durch Variation einer Regelgröße eines weiteren Reglers (82) zur In-situ-Stabilisierung des Arbeitspunktes die mittlere dynamische Beschichtungsrate (73) konstant hält.

8. Verfahren nach Anspruch 7, **dadurch gekennzeichnet, dass** die ermittelte Variation der Regelgröße (82) des zweiten Reglers (79) als Korrekturfunktion (70) in die Steuerung (28) übertragen wird.

9. Verfahren nach Anspruch 1, **dadurch gekennzeichnet, dass** die Kammerparameter die Kathodenspannung, der Gasfluss, die Temperatur und der Gasdruck sind.

10. Verfahren nach Anspruch 1, **dadurch gekennzeichnet, dass** das Substrat (5) eine Glasscheibe ist.

11. Verfahren nach Anspruch 1, **dadurch gekennzeichnet, dass** die erfasste Position der Glasscheibe (5) die Vorderkante (35) ist.

12. Verfahren nach Anspruch 1, **dadurch gekennzeichnet, dass** für die Modellbildung (40) der Beschichtungskammer (2) die Monte-Carlo-Methode verwendet wird.

13. Verfahren nach Anspruch 1, **dadurch gekennzeichnet, dass** die Beschichtung des Substrats (5) mittels Sputtern erfolgt.

14. Verfahren nach Anspruch 13, **dadurch gekennzeichnet, dass** der Sputtervorgang anhand des Berg'schen Modells abgebildet wird.

15. Verfahren nach einem oder mehreren der vorangegangenen Ansprüche, **dadurch gekennzeichnet, dass** die Beschichtungskammer (2) in mehrere Teilvolumina (44 bis 47) aufgeteilt wird und in jedem dieser Teilvolumina (44 bis 47) das Berg'sche Modell angewandt wird.

16. Verfahren nach einem oder mehreren der vorangegangenen Ansprüche, **dadurch gekennzeichnet, dass** die Modellbildung der Monte-Carlo-Methode und die Berg'sche Modellbildung mathematisch gekoppelt werden und ein gekoppeltes System zeitabhängiger Differentialgleichungen gebildet wird, welcher die Regelgrößen für die Schichtdicken-Minimierung entnommen werden können.

17. Verfahren nach Anspruch 1, **dadurch gekennzeichnet, dass** mehrere Beschichtungskammern (2) in Serie geschaltet sind und die Prozessparameter für alle Beschichtungskammern (2) durch ein Modell abgebildet werden.

**Claims**

1. Method for coating substrates in inline installations, in which a substrate is moved through at least one coating chamber and during this movement is coated, **characterized by** the following steps:

   a) a model (40) of the coating chamber (2) is formed, which takes into consideration those changes of chamber parameters, which are caused by the movement of the substrate (5) through the coating chamber (2),
   b) the position of the substrate (5) within the coating chamber (2) is acquired,
   c) the chamber parameters are set based on the position of the substrate (5) according to the model (40).

2. Method as claimed in claim 1, **characterized in that** the model (40) determines a correction function (70) for one or several chamber parameters as a function of the position of the substrate (5).

3. Method as claimed in claim 1, **characterized in that** the correction function (70) is transmitted into a control (28) of the coating installation (1).

4. Method as claimed in claim 1, **characterized in that** the dimensions of the substrate (5) are entered into the model (40).

5. Method as claimed in claim 1, **characterized in that** a mean dynamic coating rate (73) is determined on the basis of the model (40) and the determined coating rate (73) is entered as regulated variable into a virtual regulator (72), which, by variation of gas flow of discharge power (74), keeps constant the mean dynamic coating rate (73).

6. Method as claimed in claim 5, **characterized in that** the variation of the gas flow or of the discharge power (74) is transmitted as correction function (70) into the control (28).

7. Method as claimed in claim 1, **characterized in that** a mean dynamic coating rate (73) is determined based on the model (40) and the determined coating rate (73) is entered as regulated variable into a virtual regulator (83), which, by variation of a regulated variable of a further regulator (82) for the in situ stabilization of the operating point, keeps constant the mean dynamic coating rate (73).

8. Method as claimed in claim 7, **characterized in that** the determined variation of the regulated variable (82) of the second regulator (79) is transmitted into the control (28) as correction function (70).

9. Method as claimed in claim 1, **characterized in that** the chamber parameters are the cathode voltage, gas flow, temperature and gas pressure.

10. Method as claimed in claim 1, **characterized in that** the substrate (5) is a glass plate.

11. Method as claimed in claim 1, **characterized in that** the acquired position of the glass plate (5) is the front edge (35).

12. Method as claimed in claim 1, **characterized in that** for building the model (40) of the coating chamber (2) the Monte Carlo method is utilized.

13. Method as claimed in claim 1, **characterized in that** the coating of the substrate (5) takes place by sputtering.

14. Method as claimed in claim 13, **characterized in that** the sputtering process is represented by means of Berg's model.

15. Method as claimed in one or several of the preceding claims, **characterized in that** the coating chamber (2) is divided into several subvolumes (44 to 47) and Berg's model is applied in each of these subvolumes (44 to 47).

16. Method as claimed in one or several of the preceding claims, **characterized in that** the model building of the Monte Carlo method and the model building after Berg are mathematically coupled and a coupled system of time-dependent differential equations is formed, from which can be taken the regulated variables for the layer thickness minimization.

17. Method as claimed in claim 1, **characterized in that** several coating chambers (2) are arrayed in series and the process parameters for all coating chambers (2) are represented through a model.

**Revendications**

1. Procédé destiné à revêtir des substrats dans des installations inline, dans lesquels un substrat est déplacé à travers au moins une chambre de revêtement et est revêtu pendant ce mouvement, **caractérisé par** les étapes suivantes :

   a) un modèle (40) de la chambre de revêtement (2) est créé qui tient compte des modifications des paramètres de la chambre provoqués par le mouvement du substrat (5) à travers la chambre de revêtement (2) ;
   b) la position du substrat (5) à l'intérieur de la chambre de revêtement (2) est enregistrée ;
   c) les paramètres de la chambre sont réglés en fonction de la position du substrat (5) selon les dimensions du modèle (40).

2. Procédé selon la revendication 1, **caractérisé en ce que** le modèle (40) définit une fonction de correction (70) pour un ou plusieurs paramètres de chambre en fonction de la position du substrat (5).

3. Procédé selon la revendication 1, **caractérisé en ce que** la fonction de correction (70) est transmise dans une commande (28) de l'installation de revêtement (1).

4. Procédé selon la revendication 1, **caractérisé en ce que** les dimensions du substrat (5) sont entrées dans le modèle (40).

5. Procédé selon la revendication 1, **caractérisé en ce qu'**une vitesse de revêtement (73) dynamique moyenne est créée sur la base du modèle (40) et la vitesse de revêtement (73) calculée est fournie comme grandeur de réglage dans un régulateur virtuel (72) qui maintient la vitesse de revêtement moyenne (73) constante en variant l'écoulement de gaz ou par une décharge (74).

6. Procédé selon la revendication 5, **caractérisé en ce que** la variation de l'écoulement de gaz ou la décharge (74) est transmise à la commande comme fonction de correction (70).

7. Procédé selon la revendication 1, **caractérisé en ce qu'**une vitesse de revêtement (73) dynamique moyenne est créée sur la base du modèle (40) et la vitesse de revêtement (73) calculée est fournie comme grandeur de réglage dans un régulateur virtuel (72) qui maintient la vitesse de revêtement moyenne (73) constante en variant une grandeur de régulation (82) d'un autre régulateur pour la stabilisation in-situ du point de travail.

8. Procédé selon la revendication 7, **caractérisé en ce que** la variation calculée de la grandeur de régulation (82) du deuxième régulateur (79) est transmise à la commande (28) comme fonction de correction (70).

9. Procédé selon la revendication 1, **caractérisé en ce que** les paramètres de la chambre sont la tension cathodique, l'écoulement de gaz, la température et la pression du gaz.

10. Procédé selon la revendication 1, **caractérisé en ce que** le substrat (5) est une vitre en verre.

11. Procédé selon la revendication 1, **caractérisé en ce que** la position détectée de la vitre en verre (5) est l'arête avant (35).

12. Procédé selon la revendication 1, **caractérisé en ce que** pour la création du modèle (40) de la chambre de revêtement (2), on emploie la méthode Monte-Carlo.

13. Procédé selon la revendication 1, **caractérisé en ce que** le revêtement du substrat (5) est effectué par pulvérisation.

14. Procédé selon la revendication 13, **caractérisé en ce que** la pulvérisation et formée à l'aide du modèle de Berg.

15. Procédé selon l'une ou plusieurs des revendications précédentes, **caractérisé en ce que** la chambre de revêtement (2) et divisée en plusieurs volumes partiels (44 à 47) et dans chacun de ces volumes partiels (44 à 47), le modèle de Berg est employé.

16. Procédé selon l'une ou plusieurs des revendications précédentes, **caractérisé en ce que** la création du modèle de la méthode Monte-Carlo et la création du modèle de Berg sont couplées mathématiquement et un système couplé d'équations différentielles en fonction du temps est formé permettant de déduire les grandeurs de régulation pour la minimisation des épaisseurs de couche.

17. Procédé selon la revendication 1, **caractérisé en ce que** plusieurs chambres de revêtement (2) sont montées en série et les paramètres de procédé sont formés par un modèle pour toutes les chambres de revêtement (2).

# FIG.1

# FIG.2

# FIG.3

Virtueller
Regelkreis

# FIG.4

Sollwert für die
Beschichtungsrate

Weitere
Modell-
Parameter ⌐76

Substratposition
x = Fkt. (Prozess-
zeit) ⌐80

⌐78

75⌐

Mittlere dynamische
Beschichtungsrate

73⌐

Sputter-Modell ⌐40

Simulierter Reaktivgas-
Partialdruck

81⌐

83⌐

Virtuelles Regelglied I
zur Schichtdicken-
Stabilisierung

⌐82

79⌐ Virtuelles Regelglied II
zur in-situ Prozess-
Stabilisierung

Stellgröße:
Arbeitspunkt des
Reglers zur in-situ
Prozess-Stabilisierung

82

⌐28

Sollwert für Reaktivgaspartialdruck (Arbeitspunkt)

76⌐ Regelglied zur
in-situ Prozess-
Stabilisierung

⌐77

Tabellierte
Kompensationsfunktion   F(x) ⌐70

27⌐ Reaktivgaspartialdruck (IST-Wert)

Drucksensor 37

1⌐

Leitung
36⌐

29, 30
oder  33, 34

Inline-Sputteranlage

Substratposition x

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5751607 A
- US 6070735 A
- US 6512998 B
- KR 2000023859
- JP 10294293 A
- JP 2003282381 A
- US 6512998 B1
- US 20030141184 A
- US 6425988 B
- US 6524449 B
- US 6668207 B

**In der Beschreibung aufgeführte Nicht-Patentliteratur**

- **G. A. BIRD.** Recent Advances and Current Challenges for DSMC. *Computers Math. Applic.,* 1998, vol. 35 (1/2), 1-14
- **S. BERG ; H.-O. BLOM ; T. LARSSON ; C. NENDER.** Modeling of reactive sputtering of compound materials. *J. Vac. Sci. Technol.,* Marz 1987, vol. A5 (2), 202-207
- *Thin Solid Films,* 1996, vol. 289, 140-146
- **KAROL MACÄK ; PETER MACÄK ; ULF HELMERSSON.** Monte Carlo simulations of the transport of sputtered particles. *Computer Physics Communications,* 1999, vol. 120, 238-254
- **A. PFLUG ; N. MALKOMES ; V. SITTINGER ; B. SZYSZKA.** Simulation of Reactive Magnetron Sputtering Kinetics in Real In-Line Processing Chambers. *Thin Solid Films,* 2003, vol. 442, 21-26
- **A. PFLUG ; B. SZYSZKA ; V. SITTINGER ; J. NIEMANN.** Process Simulation for Advanced Large Area Optical Coatings. *Society of Vacuum Coaters,* 2003, 241-247
- **A. PFLUG ; B. SZYSZKA ; J. NIEMANN.** Simulation des reaktiven Magnetron-Sputterprozesses in In-line-Anlagen. *JOT,* 2003, vol. 1, X-XIII
- **KAROL MACÄK ; PETER MACÄK ; ULF HELMERSSON.** Monte Carlo simulations of the transport of sputtered particles. *Computer Physics Communications,* 1999, vol. 120, 238-254
- **S. BERG ; H.-O. BLOHM ; T. LARSSON ; C. NENDER.** Modeling of reactive sputtering of compound materials. *J. Vac. Sci. Technol.,* Marz 1987, vol. A5 (2), 202-207